(19) **Europäisches Patentamt**
**European Patent Office**
**Office européen des brevets**

(11) **EP 0 818 813 B1**

(12) **FASCICULE DE BREVET EUROPEEN**

(45) Date de publication et mention
de la délivrance du brevet:
**12.10.2011 Bulletin 2011/41**

(51) Int Cl.:
*H01L 21/60* <sup>(2006.01)</sup>   *H01L 23/485* <sup>(2006.01)</sup>

(21) Numéro de dépôt: **97401098.5**

(22) Date de dépôt: **16.05.1997**

(54) **Système de composants à hybrider et procédé d'hybridation autorisant des dilatations thermiques**

Bauelementsystem zum Bonden und Bondverfahren, wobei Wärmeausdehnungen möglich sind

Component system for bonding and method of bonding enabling thermal dilatations

(84) Etats contractants désignés:
**DE GB IT**

• **Chantre, Chantal**
**38180 Seyssins (FR)**

(30) Priorité: **20.05.1996 FR 9606221**

(74) Mandataire: **Poulin, Gérard et al**
**BREVALEX**
**95 rue d'Amsterdam**
**75378 Paris Cedex 8 (FR)**

(43) Date de publication de la demande:
**14.01.1998 Bulletin 1998/03**

(73) Titulaire: **Commissariat à l'Énergie Atomique
et aux Énergies Alternatives
75015 Paris (FR)**

(56) Documents cités:
**EP-A- 0 332 402   WO-A-87/01509**
**WO-A-89/08926   WO-A-94/28581**
**DE-A- 4 323 799   US-A- 5 008 512**
**US-A- 5 164 336   US-A- 5 341 979**

(72) Inventeurs:
• **Marion, François**
**38120 Saint-Egrève (FR)**

## Description

Domaine technique

La présente invention concerne un système de composants à hybrider adapté à une technique d'hybridation par fusion de billes de soudure, du type connu sous la désignation "flip-chip". L'invention concerne également un procédé de préparation de ces composants et un procédé d'hybridation utilisant ces composants.

L'invention trouve des applications notamment dans les domaines de l'électronique et de l'optique pour l'interconnexion de composants en matériaux différents.

A titre d'exemple, l'invention peut notamment être utilisée pour l'interconnexion de composants de silicium avec des composants d'AsGa ou d'InSb.

Au sens de la présente invention, on entend par composant, aussi bien un composant électronique tel qu'une puce électronique, un support de circuit électronique ou optoélectronique, qu'un composant mécanique tel qu'un capot ou un capteur de grandeurs physiques.

L'invention peut en particulier être utilisée pour la fabrication de détecteurs infrarouges, la fabrication de lasers à cavité verticale, ou pour reporter une matrice de photodiodes de lecture en AsGa sur un circuit de lecture en Si.

Etat de la technique antérieure

On distingue principalement deux techniques d'hybridation de composants par billes de soudure.

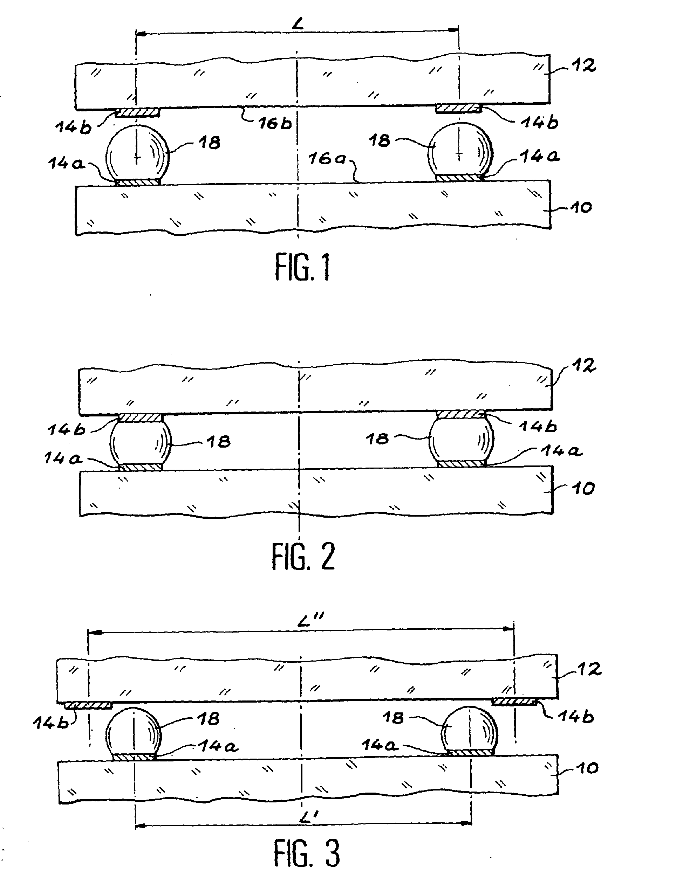

Une première technique désignée par "technique d'hybridation par fusion" (ou "flip-chip") fait appel à des billes de matériau fusible tel qu'un alliage d'étain et de plomb (SnPb) ou d'étain et d'indium (SnIn), par exemple. Cette technique est illustrée par le dessin des figures 1 et 2 annexées.

Sur ces figures, les références 10 et 12 désignent respectivement un premier et un deuxième composants à interconnecter. Le premier composant 10 comporte des premiers plots 14a de réception de billes, en un matériau mouillable par le matériau des billes de soudure. Les plots 14a sont entourés respectivement par une plage 16a de matériau non mouillable par le matériau des billes.

De la même façon, le deuxième composant 12 comporte des deuxièmes plots 14b également en un matériau mouillable par le matériau des billes et entourés par une plage 16b de matériau non mouillable.

Les premiers et deuxièmes plots 14a, 14b sont respectivement associés pour former des paires de plots et disposés en des emplacements complémentaires des premier et deuxième composants. Ainsi, les premier et deuxième plots de chaque paire de plots sont situés sensiblement face à face lorsque les composants à hybrider 10, 12 sont reportés l'un sur l'autre comme le montre la figure 1.

On considère que la figure 1 représente la structure formée par les deux composants à la température ambiante notée Ta. On désigne par L la distance qui sépare respectivement les deux plots de réception de billes représentés sur chaque composant.

Les plots 14a de l'un des composants, en l'occurrence du composant 10, sont équipés de billes 18 de matériau fusible. Ces billes 18 sont destinées à créer un lien mécanique et/ou électrique entre les plots de chaque paire de plots.

Pour effectuer une hybridation, le composant 12 est reporté sur le composant 10 de manière à mettre en contact les plots 14b sur les billes 18 correspondantes. L'ensemble de la structure est ensuite porté à une température supérieure ou égale à la température de fusion des billes pour provoquer le soudage des billes 18 sur les plots 14b.

L'ensemble des billes sont ainsi soudées simultanément sur les plots 14b du composant 12, qui leurs correspondent. Après refroidissement, on obtient la structure de la figure 2. Sur cette figure, chaque plot 14a du composant 10 est relié mécaniquement et électriquement à un plot 14b correspondant du composant 12, par une bille 18 de soudure.

La précision du positionnement mutuel des composants lors du report du composant 10 sur le composant 12 n'est pas très critique. En effet, lors de la fusion du matériau des billes les composants 10 et 12 s'alignent automatiquement sous l'effet de la tension superficielle du matériau des billes fondu.

Grâce au procédé d'hybridation décrit, toutes les soudures entre les billes et les plots de réception sont réalisées simultanément. Le procédé d'hybridation par fusion est particulièrement adapté à l'hybridation d'une pluralité de composants, tels que des puces, sur un composant de réception formant un substrat. Un rendement d'hybridation élevé peut être obtenu pour ces structures.

Les figures 1 et 2 illustrent une mise en oeuvre du procédé d'hybridation par fusion pour des composants qui sont de petite taille ou qui présentent des coefficients de dilatation très voisins.

Lorsque les composants à hybrider présentent des coefficients de dilatation différents, et surtout lorsqu'une distance non négligeable sépare les différents plots, un désalignement entre les plots des deux composants se produit lorsque la structure est portée à une température supérieure ou égale à la température de fusion du matériau des billes.

Cette situation est illustrée par la figure 3 qui montre les composants à la température d'hybridation Th. On considère que le matériau du composant 12 présente un coefficient de dilatation $\alpha_2$ supérieur au coefficient de dilatation $\alpha_1$ du matériau du composant 10. Lorsque la structure est portée à la température d'hybridation Th, les plots 14a du composant 10, et par conséquent les billes 18, sont distants d'une distance L' telle que :

$$L' = L(1 + \alpha_1 . \Delta T)$$

où L est la distance réparant les mêmes plots 14a à la température ambiante Ta (figure 1), et $\Delta T$ est défini par $\Delta T = Th - Ta$.

De la même façon, à la température d'hybridation Th, les plots 14b sur le composant 12 sont distants d'une distance L" telle que :

$$L'' = L(1 + \alpha_2 . \Delta T).$$

Dans le cas particulier de la figure 3 où chaque composant ne comporte que deux plots de réception des billes, le désalignement $\Delta L$ entre chaque plot 14b et chaque bille 18 correspondante est alors tel que :

$$\Delta L = L / 2 . \Delta \alpha . \Delta T,$$

où $\Delta \alpha = \alpha_2 - \alpha_1$.

Le désalignement entre les plots de réception de billes des substrats à hybrider peut dans certains cas être suffisamment important pour compromettre l'opération d'hybridation.

A titre d'exemple, lorsque le substrat 10 est en silicium ($\alpha_1$ (Si)=2.10$^{-6}$) et le substrat 12 en arséniure de gallium ($\alpha_2$(AsGa)=8.10$^{-5}$), lorsque la distance entre les billes 18 à une température ambiante de 20°C est de 2 cm et lorsque la température d'hybridation des billes 18 en alliage étain-plomb (60/40) est de l'ordre de 220°C, le décalage latéral entre chaque plot 14b et chaque bille 18 correspondante est $\Delta L = 12 \ \mu m$.

De telles valeurs sont atteintes par exemple pour des composants sous forme de barrettes ayant 1000 plots de connexion en ligne avec un pas de 20 $\mu m$.

Dans un tel cas, si la surface mouillable des plots de connexion a un diamètre de 12 $\mu m$ par exemple, seules les billes pour lesquelles le décalage $\Delta L$ est inférieur ou égal à 6$\mu m$ peuvent être connectées selon le procédé d'hybridation par fusion. En effet, seules ces billes sont en contact avec les plots de réception du deuxième composant.

WO-A-94 28581 propose une solution au problème rencontré lorsqu'on hybride une puce et un substrat présentant des coefficients de dilatation différents en utilisant des billes en matériau fusible. Ici, à température ambiante, les plots de la puce sont reliés aux plots du substrat par des billes de matériau fusible non déformées, les plots de la puce étant situés en vis-à-vis des plots du substrat. Cependant, lorsque la température augmente ou diminue, les billes subissent des déformations du fait de la différence des coefficients de dilatation entre la puce et le substrat. La solution proposée dans WO-A-94 28581 pour résoudre le problème est de placer un cordon d'étanchéité et de tenue mécanique entre le substrat et la puce afin d'améliorer la tenue mécanique de l'ensemble constitué de la puce, du substrat et des billes d'hybridation.

Pour répondre à ces difficultés il existe une deuxième technique d'hybridation par billes de soudure. Cette deuxième technique est désignée par technique d'hybridation par pression.

Selon cette technique on part d'une structure comparable à la structure représentée à la figure 1. Le composant 12 est reporté sur le composant 10 en faisant coïncider très précisément les plots 14b avec les billes 18. Puis, en exerçant des forces adaptées sur les composants 10 et 12, les billes 18 sont pressées fermement contre les plots 14b pour réaliser une liaison par thermocompression.

Cette opération peut avoir lieu à une température inférieure à la température de fusion du matériau des billes, et en particulier à une température voisine de la température ambiante.

Ainsi, en limitant les excursions en température $\Delta T$ le problème d'un désalignement entre les plots 14b et les billes 18, ou les plots 14a, ne se pose pas, même lorsque les composants sont en des matériaux avec des coefficients de dilatation différents.

Toutefois, la technique d'hybridation par pression présente, par rapport à la technique d'hybridation par fusion, un certain nombre de désavantages.

Par exemple, pour l'hybridation par pression, l'alignement des composants à hybrider doit être effectué avec une très grande précision. En effet, le phénomène d'auto-alignement décrit ci-dessus ne se produit pas à des températures inférieures à la température de fusion du matériau des billes.

De plus, contrairement à l'hybridation par fusion, l'hybridation par pression est inadaptée pour la connexion simultanée de nombreux composants au cours d'une même opération.

L'hybridation par pression autorise par ailleurs des rendements d'hybridation plus faibles.

A titre d'illustration, US 5,164,336 décrit un procédé permettant de connecter une bande de soudage sur bande (TAB) et une puce semiconductrice par thermocompression. US 5,341,979 décrit quant à lui un procédé permettant de relier deux substrats en utilisant un dispositif de liaison thermosonique.

Finalement, un but de la présente invention est de proposer un système de composants à hybrider de même qu'un procédé de préparation et d'hybridation des composants, qui ne présentent pas les désavantages ni les limitations évoqués ci-dessus.

Un but de l'invention est en particulier de proposer un système de composants à hybrider et un procédé d'hybridation ne présentant pas les problèmes de désalignement à la température d'hybridation.

Un but est également de proposer un procédé d'hybridation permettant l'interconnexion simultanée d'un grand nombre de composants.

Un but de l'invention est encore de proposer un système de composants à hybrider et un procédé d'hybridation permettant un auto-alignement des composants.

Exposé de l'invention

Pour atteindre les buts mentionnés, l'invention a plus précisément pour objet un système de composants à hybrider selon la revendication indépendante 1.

Le décalage mutuel des plots est compris comme un décalage parallèle aux faces d'hybridation des composants en regard.

On considère par ailleurs que les premier et deuxième composants sont reportés l'un au-dessus de l'autre lorsqu'un barycentre des premiers et un barycentre des deuxièmes plots respectivement sur les premier et deuxième composants, sont superposés.

Comme les premiers et deuxièmes plots sont associés en paires de plots superposables à la température d'hybridation et que le barycentre des plots est défini comme étant invariable lors d'une dilatation, un même point projeté respectivement sur chacun des composants est défini par le barycentre des premiers plots et le barycentre des deuxièmes plots lorsque le deuxième composant est reporté sur le premier composant. Ce point est désigné par barycentre des premiers et deuxièmes plots.

Grâce aux caractéristiques de l'invention, un désalignement entre les plots de réception des billes existe à la température ambiante mais disparaît à la température d'hybridation Th.

On entend par température d'hybridation Th une température supérieure ou égale à la température de fusion du matériau des billes de soudure, à laquelle est réalisée l'hybridation.

La distance de décalage mutuel des plots formant des paires de plots est calculée de préférence de telle manière que ce décalage soit sensiblement nul lorsque la température Th est atteinte.

Ainsi, selon un aspect de l'invention, la distance de compensation entre les premiers et deuxième plots de chaque paire de plots est proportionnelle à :

- une distance séparant les premier et deuxième plots de leur barycentre respectif,
- une différence de température entre la température ambiante Ta et la température d'hybridation Th et
- à une différence entre les premier et deuxième coefficients de dilatation.

Dans un cas où le deuxième coefficient de dilatation du matériau du deuxième composant est supérieur au premier coefficient de dilatation du matériau du premier composant, les deuxièmes plots sont disposés en une position décalée à la température ambiante, par rapport aux premiers plots correspondants, dans un sens qui les rapproche de leur barycentre sur le deuxième composant.

Lorsque la température des composants est augmentée jusqu'à la valeur Th, à la fois les premiers et deuxièmes plots s'éloignent respectivement du barycentre des premiers et seconds plots sous l'effet de la dilatation.

Cependant, si le deuxième coefficient de dilatation est supérieur au premier coefficient de dilatation le déplacement des deuxièmes plots est plus important et compense le décalage initialement prévu.

De façon plus précise, selon une réalisation particulière du système de composants de l'invention, les premier et deuxième plots de chaque paire de plots (i) sont formés en un emplacement tel qu'à la température ambiante, ils sont respectivement distants de leur barycentre respectif d'une distance $d_1(i)$ et $d_2(i)$ telles que $d_1(i)(1+\alpha_1\Delta T)=d_2(i)(1+\alpha_2\Delta T)$ où $\alpha_1$ et $\alpha_2$ sont respectivement les premier et deuxième coefficients de dilatation et où $\Delta T$ est la différence entre la température d'hybridation et la température ambiante.

Au moins l'un des plots de chaque paire de plots est équipé d'une bille de matériau fusible, par exemple une bille en alliage SnPb.

Selon une réalisation particulière des premier et deuxième composants les premiers plots sont équipés de billes de matériau fusible tandis que les deuxièmes plots en sont dépourvus.

L'invention a également pour objet un procédé de préparation d'au moins un premier et au moins un second composants pour leur hybridation par billes de soudure selon la revendication 5,

L'invention concerne également un procédé d'hybridation selon la revendication 6.

D'autres caractéristiques et avantages de l'invention ressortiront mieux de la description qui va suivre, en référence aux figures des dessins annexés, donnée à titre purement illustratif et non limitatif.

Brève description des figures

- la figure 1, déjà décrite, est une coupe schématique d'un système de composants à hybrider, à température ambiante, illustrant des techniques connues d'hybridation,
- la figure 2, déjà décrite, est une coupe schématique du système de composants de la figure 1 après hybridation,
- la figure 3, déjà décrite, est une coupe schématique du système de composants à hybrider de la figure 1 à une température supérieure à la température ambiante, dans lequel les composants sont en des matériaux présentant des coefficients de dilatation différents.
- La figure 4 est une coupe schématique avant hybridation d'un système de composants à hybrider conforme à l'invention et à la température ambiante,

- la figure 5 est une coupe schématique du système de composants de la figure 4 à une température d'hybridation des composants, et
- la figure 6 est une coupe schématique du système de composants de la figure 4 à la température ambiante, après hybridation.

<u>Description détaillée de modes de mise en oeuvre de l'invention</u>

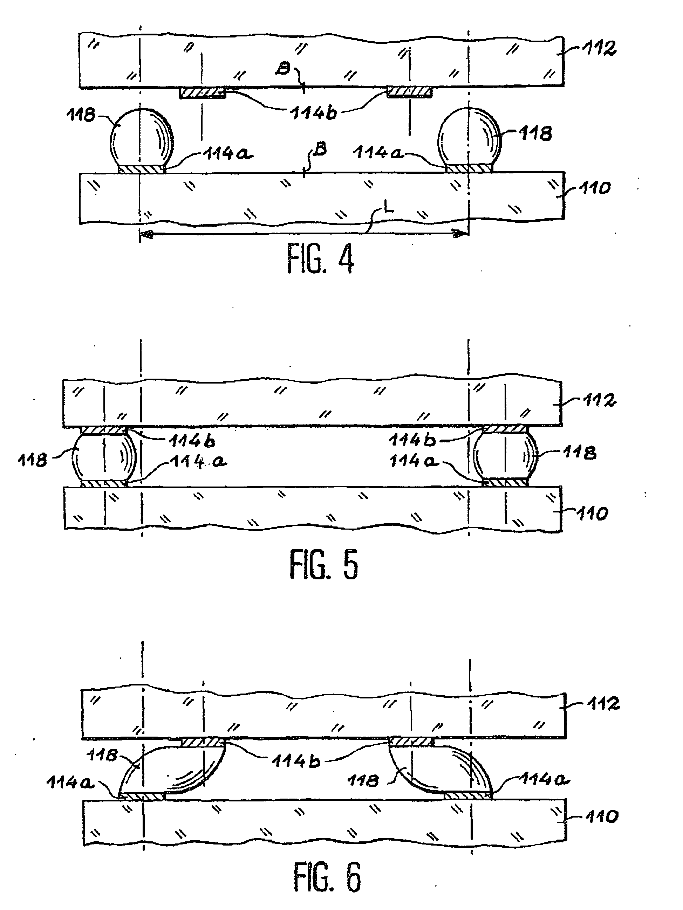

Des références identiques à celles utilisées sur les figures 1 à 3 auxquelles on a ajouté 100, sont affectées à des éléments identiques ou similaires des figures 4 à 6.

La figure 4 montre un système de composants conforme à l'invention. Ce système comporte un premier composant 110 équipé de plots de réception de billes 114a et un deuxième composant 112 équipé de plots de réception de billes 114b. Le composant 110 correspond, par exemple, à un substrat et le composant 112 est, par exemple, une puce électronique à reporter sur le substrat. Pour des raisons de simplification, on considère que les composants doivent être reliés électriquement et/ou mécaniquement par seulement deux billes de matériau fusible. Les plots 114a et 114b sont en un matériau mouillable par les billes, par exemple du cuivre et sont entourés par un matériau non mouillable par les billes.

Les plots 114a sont équipés de billes 118 de soudure, par exemple, en un alliage SnPb (40/60).

La formation de billes sur des plots d'accrochage peut avoir lieu selon un procédé connu, par exemple, en faisant croître par électrolyse le matériau des billes au-dessus des plots puis en mettant en forme ce matériau par chauffage.

Sur la figure 4, les composants 110 et 112 sont représentés dans leur état à la température ambiante, par exemple 20°C, juste avant l'opération d'hybridation.

On désigne par L la distance séparant les billes 118 sur le composant 110. Chaque bille 118 est donc distante du barycentre des billes d'une distance L/2 en considérant que dans l'exemple illustré le composant n'est équipé que des deux billes visibles sur la figure.

Le barycentre des billes ou des plots 114a dans un plan parallèle à la surface du composant 110 est considéré comme superposé, à une erreur de positionnement des composants près, au barycentre des plots 114b sur le composant 112. Sur la figure 4, le barycentre est indiqué avec la lettre B à la surface des composants.

Les plots 114b sont chacun décalés en direction du barycentre B sur le composant 112, d'une distance correspondant à la dilatation différentielle des deux composants.

Dans le cas de l'exemple de la figure 4, chaque plot 114b est décalé vers le barycentre d'une distance d telle que : $d=(L/2).\Delta\alpha.\Delta\gamma$, où $\Delta\alpha$ est la différence entre le coefficient de dilatation $\alpha_2$ du matériau du composant 112 et le coefficient de dilatation $\alpha_1$ du matériau du composant 110.

La figure 5 montre les composants 110 et 112 portés à la température d'hybridation Th.

En passant de la température ambiante à la température d'hybridation le composant 112 s'est davantage dilaté que le composant 110 et ses plots 114b se trouvent désormais en face des plots 114a.

Le composant 112 est abaissé et le matériau des billes en fusion vient se souder sur les plots 114b. Le centrage des composants 110 et 112 l'un sur l'autre a lieu à la température d'hybridation sous l'effet de forces de tension superficielle dans le matériau des billes.

La figure 6 montre la structure obtenue après refroidissement. Les composants 110 et 112 se contractent lors du refroidissement et les plots 114a et 114b retrouvent sensiblement la position initiale telle que représentée à la figure 4.

On constate également sur la figure 5 que le matériau des billes a subi une déformation de sorte que chaque bille relie toujours les plots 114a et 114b qui lui correspondent.

Finalement, il apparaît que la réalisation d'une hybridation conformément à l'invention ne nécessite pas d'étape supplémentaire par rapport à l'hybridation connue par fusion.

Cependant, lors de la conception des faces d'assemblage des composants, la position des plots de réception des billes est calculée de telle façon qu'il y ait un décalage à la température ambiante mais que ce décalage se compense par un jeu de dilatation différentielle des composants.

Dans des applications particulières seule une partie d'un élément à hybrider peut être concernée par le procédé de préparation des composants de l'invention. Cette partie est alors considérée comme un composant à hybrider au sens de l'invention.

**Revendications**

**1.** Système de composants à hybrider comprenant au moins un premier composant (110) avec des premiers plots (114a) de réception de billes de soudure (118) et présentant un premier coefficient de dilatation thermique ($\alpha_1$) et au moins un deuxième composant (112) avec des deuxièmes plots (114b) de réception de billes de soudure (118) et présentant un deuxième coefficient de dilatation thermique ($\alpha_2$ différent du premier coefficient de dilatation thermique ($\alpha_1$), les premiers et deuxièmes plots étant respectivement associés deux à deux pour former des paires de plots et les premiers et/ou les deuxièmes plots étant équipés de billes de soudure (118), **caractérisé en ce que**, à une température ambiante Ta, les plots (114a, 114b) occupent une position telle que lors d'un report du deuxième composant (112) sur le premier composant (110) tel qu'un barycentre des premiers et un barycentre des deuxièmes plots respectivement sur les premier et deuxième composants sont superposés, les premier et deuxième plots (114a, 114b) de chaque pairs de plots sont mutuellement décalés, selon une direction reliant les plots de chaque paire de plots à leur barycentre respectif, d'une distance de compensation d'une dilatation différentielle des premier et deuxième composants (110, 112) entre la température ambiante (Ta) et la température d'hybridation (Th), la température d'hybridation (Th) étant une température supérieure ou égale à la température de fusion de la matière des billes de soudure et supérieure à la température ambiante (Ta), les premier et deuxième plots (114a, 114b) de chaque paire de plots étant sensiblement superposables à cette température d'hybridation.

2. Système selon la revendication 1, **caractérisé en ce que** la distance de compensation entre les premier et deuxième plots (114a, 114b) de chaque paire de plots est proportionnelle à :

   - une distance séparant respectivement les premier et deuxième plots (114a, 114b) de leur barycentre (B) respectif,
   - une différence de température entre la température ambiante Ta et la température d'hybridation Th et
   - à une différence entre les premier et deuxième coefficients de dilatation ($\alpha_1$, $\alpha_2$).

3. Système selon la revendication 1 ou 2, **caractérisé en ce que** le deuxième coefficient de dilatation ($\alpha_2$) étant supérieur au premier coefficient de dilatation ($\alpha_1$), les deuxièmes plots (114b), à la température ambiante, sont disposés en une position décalée par rapport aux premiers plots correspondants, dans un sens qui les rapproche de leur barycentre (B) sur le deuxième composant.

4. Système selon la revendication 1, **caractérisé en ce que** les premier et deuxième plots (114a, 114b) de chaque paire de plots (i) sont formés en un emplacement tel qu'à la température ambiante ils sont respectivement distants de leur barycentre (B) respectif d'une distance $d_1(i)$ et $d_2(i)$ telles que $d_1(i)(1+\alpha_1\Delta T)=d_z(i)(1+\alpha_2\Delta T)$ où $\alpha_1$ et $\alpha_2$ sont respectivement les premier et deuxième coefficients de dilatation et où $\Delta T$ est la différence entre la température d'hybridation et la température ambiante.

5. Procédé de préparation d'au moins un premier et au moins un deuxième composants (110, 112) pour leur hybridation par billes de soudure (118), le premier composant (110) comportant des premiers plots (114a) de réception des billes de soudure (118), et présentant un premier coefficient de dilatation thermique ($\alpha_1$), le deuxième composant (112) comportant des deuxièmes plots (114b) de réception des billes de soudure (118) et présentant un deuxième coefficient de dilatation thermique ($\alpha_2$) différent du premier coefficient de dilatation thermique ($\alpha_1$), les premiers et deuxièmes plots étant respectivement associés deux à deux pour former des paires de plots, **caractérisé en ce qu'**on forme les premiers et deuxièmes plots (114a, 114b) sur les premier et deuxième composants en des emplacements tels que :

   - à une température Th d'hybridation, les premier et deuxième plots (114a, 114b) de chaque paire de plots sont sensiblement superposables et
   - à une température ambiante Ta, les plots occupant lors d'un report du deuxième composant (112), sur le premier composant (110) une position telle qu'un barycentre des premiers et un barycentre des deuxièmes plots respectivement sur les premier et deuxième composants sont superposés, les plots de chaque paire de plots sont mutuellement décalés selon une direction reliant les premiers et deuxièmes plots à leur barycentre respectif d'une distance de compensation d'une dilatation différentielle des premier et deuxième composants entre les températures ambiante Ta et d'hybridation Th,

puis on équipe les premiers plots et/ou les deuxièmes plots de billes de soudure (118) de matériau fusible, la température d'hybridation (Th) étant une température supérieure ou égale à la température de fusion de la matière des billes de soudure et supérieure à la température ambiante (Ta).

6. Procédé d'hybridation par billes de soudure (118) d'au moins un premier composant (110) avec au moins un deuxième composant (112), **caractérisé en ce que** :

   - on équipe les premier et deuxième composants de plots (114a, 114b) de réception des billes de soudure (118) et de billes de soudure (118), conformément au procédé de préparation selon la revendication 5,
   - on reporte l'un sur l'autre les premier et deuxième composants (110, 112) de façon à ce qu'un barycentre des premiers et un barycentre des deuxièmes plots respectivement sur les premier et deuxième composants soient superposés**,**
   - on porte l'ensemble des premiers et deuxièmes composants (110, 112), et les billes de soudure (118), à une température d'hybridation (Th) pour sensiblement superposer et interconnecter les premier et deuxième plots (114a, 114b) de chaque paire de plots par soudage des billes de soudure (18) sur ces plots,
   - on fait refroidir la structure ainsi obtenue.

## Claims

1. System of components to be hybridized comprising at least one first component (110) with first pads (114a) for receiving solder balls (118) and having a first coefficient of thermal expansion ($\alpha_1$) and at least one second component (112) with second pads (114b) for receiving solder balls (118) and having a second coefficient of thermal expansion ($\alpha_2$) different from said first coefficient of thermal expansion ($\alpha_1$), the first and second pads being associated respectively in pairs to form pairs of pads and the first and/or second pads being equipped with solder balls (118), **characterized in that**, at ambient temperature (Ta), the pads (114a, 114b) occupy a position such that when the second component (112) is placed above the first component (110) such that a barycentre of the first pads and a barycentre of the second pads on the first and second components, respectively, are superposed, the first and second pads (114a, 114b) of each pair of pads are mutually offset along a direction connecting the pads of each pair of pads to their respective barycentre, by a compensation distance of a differential expansion of the first and second components (110, 112) between the ambient temperature (Ta) and the hybridization temperature (Th), the hybridization temperature (Th) being a temperature greater than or equal to the fusion temperature of the material of the solder balls and greater than the ambient temperature (Ta), the first and second pads (114a, 114b) of each pair of pads being approximately superposable at said hybridization temperature.

2. System according to claim 1, **characterized in that** the compensation distance between the first and second pads (114a, 114b) of each pair of pads is proportional to:

   - a distance separating the first and second pads (114a, 114b) from their respective barycentre (B), respectively;
   - a temperature difference between the ambient temperature Ta and the hybridization temperature Th; and
   - a difference between the first and second coefficients of expansion ($\alpha_1$, $\alpha_2$).

3. System according to claim 1 or 2, **characterized in that**, the second coefficient of expansion ($\alpha_2$) being greater than the first coefficient of expansion ($\alpha_1$), the second pads (114b), at ambient temperature, are placed in a position which is offset from the corresponding first pads, along a direction bringing them towards their barycentre (B) on the second component.

4. System according to claim 1, **characterized in that** the first and second pads (114a, 114b) of each pair of pads (i) are formed at a location such that at ambient temperature they are at a distance from their respective barycentre (B) by a distance $d_1(i)$ and $d_2(i)$ such that $d_1(i)(1+\alpha_1\Delta T)=d_z(i)(1+\alpha_2\Delta T)$, where $\alpha_1$ and $\alpha_2$ are the first and second coefficients of expansion respectively and where $\Delta T$ is the difference between the hybridization temperature and the ambient temperature.

5. Process for preparing at least one first and at least one second components (110, 112) for their hybridization by solder balls (118), the first component (110) comprising first pads (114a) for receiving solder balls (118) and having a first coefficient of thermal expansion ($\alpha_1$), the second component (112) comprising second pads (114b) for receiving solder balls (118) and having a second coefficient of thermal expansion ($\alpha_2$) different from said first coefficient of thermal expansion ($\alpha_1$), the first and second pads being associated in pairs respectively to form pairs of pads, **characterized in that** the first and second pads (114a, 114b) are formed on the first and second components at locations such that:

   - at hybridization temperature (Th), the first and second pads (114a, 114b) of each pair of pads are approximately superposable and
   - at ambient temperature (Ta), the pads occupy a position such that when the second component (112) is placed above the first component (110) such that a barycentre of the first pads and a barycentre of the second pads on the first and second components, respectively, are superposed, the first and second pads in each pair of pads are mutually offset, along a direction connecting the first and second pads to cheir respective barycentre, by a compensation distance of differential expansion of the first and second components between ambient temperature (Ta) and hybridization temperature (Th), then the first pads and/or the second pads are equipped with solder balls (118) made of a meltable material, the hybridization temperature (Th) being a temperature greater than or equal to the fusion temperature of the material of the solder balls and greater than the ambient temperature (Ta).

6. Hybridization process using solder balls (118), of at least one first component (110) with at least one second component (112), **characterized in that** it comprises the steps of:

   - equipping the first and second components with pads (114a, 114b) for receiving solder balls (118) and with solder balls (118), in accordance with the preparation process according to claim 5;
- placing the first and second components on each other (110; 112) such that a barycentre of the first and a barycentre of the second pads on the first and second components, respectively, are superposed;
- increasing the temperature of the first and second components (110, 112) and solder balls (118) to the hybridization temperature (Th) to approximatively superpose and interconnect the first and second pads (114a, 114b) of each pairs of pads by soldering the solder balls (118) on these pads;
- cooling the structure thus obtained.

**Patentansprüche**

1. System hybridisierbarer Bauteile, das wenigstens ein erstes Bauteil (110) mit Kontakten bzw. Kontaktflächen (114 a) zur Aufnahme von Lötkugeln (118) umfasst und einen ersten Wärmeausdehnungs-Koeffizienten WAK (a1) besitzt und das wenugstens ein zweites Bauteil (112) mit zweiten Kontakten bzw. Kontaktflächen (114b) zur Aufnahme von Lötkugeln (118) umfasst und einen von dem ersten Wärmeausdehnungskoeffizienten (a1) verschiedenen zweiten Wärmeausdehnungskoeffizienten WAK (a2) besitzt, wobei die ersten und zweiten Kontakte bzw. Kontaktflächen jeweils zu zweien einander zur Bildung von Kontakt- bzw. Kontaktflächen - Paaren zugeordnet sind und die ersten und/oder die zweiten Kontakte bzw. Kontaktflächen mit Lötkugeln (118) versehen sind, **dadurch gekennzeichnet, dass** bei einer Umgebungstemperatur (Ta) die Kontakte bzw. Kontaktflächen (114 a, 114 b) eine solche Lage einnehmen, dass beim Auflegen des zweiten Bauteils (112) auf das erste Bauteil (110) derart, dass jeweils ein Schweremittelpunkt (Schwerpunkt) der ersten und ein Schwerpunkt der zweiten Kontakte bzw. Kontaktflächen auf dem ersten bzw. dem zweiten Bauteil übereinander liegen, die ersten und die zweiten Kontakte bzw. Kontaktflächen (114 a, 114 b) jedes Kontakt- bzw. Kontaktflächenpaars entlang einer die Kontakte bzw. Kontaktflächen des Kontakt- bzw. Kontaktflächenpaars mit ihrem jeweiligen Schwerpunkt verbindenden Linie relativ gegeneinander versetzt sind um einen Abstand zur Kompensation einer unterschiedlichen Ausdehnung der ersten und zweiten Bauteile (110, 112) zwischen der Umgebungstemperatur (Ta) und der Hybridisierungs-Temperatur (Th), wobei die Hybridisierungstemperatur (Th) eine Temperatur größer als die oder gleich der Schmelztemperatur des Materials der Lötkugeln und größer als die Umgebungstemperatur (Ta) ist und wobei die ersten und zweiten Kontakte bzw. Kontaktflächen (114 a, 114 b) jedes Kontakt- bzw. Kontaktflächenpaars bei dieser Hybridisierungstemperatur im wesentlichen übereinander zu liegen kommen.

2. System nach Anspruch 1, **dadurch gekennzeichnet, dass** der Kompensationsabstand zwischen den ersten und zweiten Kontakten bzw. Kontaktflächen (114 a, 114 b) jeweils jedes Kontakt- bzw. Kontaktflächenpaars proportional ist zu:

   - einem Abstand, welcher die ersten bzw. zweiten Kontakte bzw. Kontaktflächen (114 a, 114 b) von ihrem jeweiligen Schwerpunkt (Schweremittelpunkt) trennt,
   - einer Temperaturdifferenz zwischen der Umgebungstemperatur (Ta) und der Hybridisierungstemperatur (Th),
   - einer Differenz zwischen dem ersten und zweiten Wärmeausdehnungskoeffizienten (a1, a2).

3. System nach Anspruch 1 oder 2, **dadurch gekennzeichnet, dass** der zweite Wärmeausdehnungskoeffizient WAK (a2) über dem ersten Wärmeausdehnungskoeffizienten WAK (a1) liegt, dass die zweiten Kontakte bzw. Kontaktflächen (114 b) bei der Umgebungstemperatur in einer Stellung angeordnet sind, welche relativ bezüglich der entsprechenden ersten Kontakte bzw. Kontaktflächen in einem Richtungssinn versetzt sind, der sie ihrem Schweremittelpunkt (Schwerpunkt) (B) auf dem zweiten Bauteil annähert.

4. System nach Anspruch 1, **dadurch gekennzeichnet, dass** die ersten und zweiten Kontakte bzw. Kontaktflächen (114 a, 114 b) jedes Kontaktpaars an einer solchen Stelle ausgebildet sind, dass sie von ihrem betreffenden Schwerpunkt (B) um einen Abstand $d_1(i)$ und $d_2 (i)$ entfernt sind, derart dass $d_1 (i) (1+a_1 DT)=d_2 (i) (1+a_2 DT)$, worin a1 und a2 der erste bzw. zweite Weärmeausdehnungskoeffizient WAK sind und DT die Differenz zwischen der Hybridisierungstemperatur und der Umgebungstemperatur sind.

5. Verfahrern zur Vorbereitung wenigstens eines ersten und wenigstens eines zweiten Bauteils (110, 112) für ihre Hybridisierung mittels Lötkugeln (118), wobei das erste Bauteil (110) erste Kontakte bzw. Kontaktflächen (114 a) zur Aufnahme von Lötkugeln (118) aufweist und einen ersten Wärmeausdehnungskoeffizienten WAK (a1) besitzt und das zweite Bauteil (112) zweite Kontakte bzw. Kontaktflächen (114 b) zur Aufnahme von Lötkugeln (118) aufweist und einen vom ersten Wärmeausdehnungskoeffizienten WAK (a1) verschiedenen WAK (a2) besitzt, wobei die ersten und die zweiten Kontakte bzw, Kontaktflächen jeweils zu zweien einander zur Bildung von Kontakt- bzw. Kontaktflächenpaaren zugeordnet sind, **dadurch gekennzeichnet, dass** man die ersten und zweiten Kontakte bzw. Kontaktflächen (114 a, 114 b) auf dem ersten bzw. zweiten Bauteil so ausbildet, dass:

- bei einer Hybridisierungstemperatur Th die ersten und zweiten Kontakte (114 a, 114 b) jedes Kontaktpaars im wesentlichen übereinander zu liegen kommen, und
- bei einer Umgebungstemperatur Ta die Kontakte bzw. Kontaktflächen beim Auflegen des zweiten Bauteils (112) auf das erste Bauteil (110) eine solche Lage einnehmen, dass ein Schweremittelpunkt (Schwerpunkt) der ersten Kontakte und ein Schwerpunkt der zweiten Kontakte jeweils auf dem ersten bzw. dem zweiten Bauteil übereinander liegen, wobei die Kontakte jedes Kontaktpaars längs einer die ersten und die zweiten Kontakte mit ihren jeweiligen Schwerpunkten verbindenden Linie gegeneinander um einen Abstand versetzt sind zur Kompensation einer unterschiedlichen Ausdehnung des ersten und des zweiten Bauteils zwischen der Umgebungstemperatur Ta und der Hybridisierungstemperatur,

und daß man sodann die ersten und/oder die zweiten Kontakte bzw. Kontaktflächen mit Lötkugeln (118) aus einem schmelzbaren Material versieht, wobei die Hybridisierungstemperatur (Th) eine Temperatur ist, die höher als die oder gleich der Schmelztemperatur der Lötkugeln und höher als die Umgebungstemperatur ist.

6. Verfahren zum Hybridisieren mittels Lötkugeln (118) wenigstens eines ersten Bauteils (110) mit wenigstens einem zweiten Bauteil (112), **dadurch gekennzeichnet, dass** man:

- man die ersten und die zweiten Bauteile mit Kontakten bzw. Kontaktflächen (114a, 114b) zur Aufnahme von Lötkugeln und mit Lötkugeln (118) versieht, nach dem Verfahren gemäß Anspruch 5,
- dass man von den ersten und zweiten Bauteilen (110, 112) eines auf/über das andere legt, derart dass ein Schweremittelpunkt (Schwerpunkt) der ersten Kontakte und ein Schwerpunkt der zweiten Kontakte auf den ersten bzw. zweiten Bauteilen übereinander zu liegen kommen,
- dass man das Ganze aus den ersten und zweiten Bauteilen (110, 112) und den Lötkugeln (118) auf eine Hybridisierungstemperatur (Th) bringt, um die im wesentlichen übereinander liegenden ersten und zweiten Kontakte bzw. Kontaktflächen (114 a, 114 b) jedes Kontaktpaars durch Lötung des Lötkugeln (118) auf den Kontakten bzw Kontaktflächen mit einander zu verbinden,

- dass man das so erhaltene Strukturgebilde abkühlt.

FIG. 1

FIG. 2

FIG. 3

FIG. 4

FIG. 5

FIG. 6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 9428581 A
- US 5164336 A
- US 5341979 A